# FASCICULE DE BREVET EUROPEEN

(11) **EP 3 845 978 B1**
(45) Date de publication et mention de la délivrance du brevet: **09.10.2024**
(21) Numéro de dépôt: 20204561.3
(22) Date de dépôt: 29.10.2020
(51) Int. Cl.: G05B 9/02

(54) **DISPOSITIF DE COMMANDE SÉCURISÉE, CONTACTEUR COMPORTANT UN TEL DISPOSITIF ET PROCÉDÉ DE TRAITEMENT SÉCURISÉ D'UN SIGNAL DE COMMANDE**
SICHERE STEUERUNGSVORRICHTUNG, KONTAKTOR MIT EINER SOLCHEN VORRICHTUNG UND VERFAHREN ZUR SICHEREN VERARBEITUNG EINES STEUERSIGNALS
SECURE CONTROL DEVICE, CONTACTOR COMPRISING SUCH A DEVICE AND METHOD FOR SECURE PROCESSING OF A CONTROL SIGNAL

(30) Priorité: 28.11.2019 FR 1913362
(43) Date de publication de la demande: 07.07.2021
(73) Titulaire: Schneider Electric Industries SAS, 92500 Rueil-Malmaison (FR)
(72) Inventeur: LANES, David, 38000 Grenoble (FR)
(74) Mandataire: Lavoix

(56) Documents cités:
- EP-A2- 0 897 210
- EP-A2- 1 172 662
- FR-A1- 2 400 229
- FR-A1- 2 725 857
- US-A1- 2016 118 212
- US-A1- 2019 068 088

## Description

### Domaine technique

La présente invention concerne un dispositif de commande sécurisée destiné, en particulier, à la commande d'un contacteur. L'invention concerne également un procédé de traitement sécurisé d'un signal de commande de fermeture ou d'ouverture d'un contacteur et un contacteur comportant un dispositif de commande sécurisée.

### Etat de la technique

De nombreux équipements comportent un ou plusieurs contacteurs pour commander une mise sous tension ou hors tension d'appareils électriques tels que des machines de production, des moteurs, des équipements de soudage, etc. Certains équipements dont le fonctionnement présente un caractère dangereux, nécessitent une sécurité accrue de leur commande et doivent disposer en particulier d'un moyen d'arrêt d'urgence pour interrompre le fonctionnement en cas de danger. Pour renforcer la sûreté des biens et des personnes, une commande de mise en fonctionnement d'un moteur électrique peut faire l'objet d'une validation afin d'éviter toute commande intempestive induite, par exemple, par des perturbations électromagnétiques. Dans ce cas, quand une commande n'est pas valide, l'équipement doit être mis dans un état de sécurité correspondant généralement à un arrêt de l'équipement.

On connait le document EP 1 538 651 A2 portant sur un circuit d'arrêt d'urgence comportant deux lignes fonctionnant en parallèle, chaque ligne comportant des contacts dont l'actionnement est commandé par des unités centrales. L'alimentation des commandes des contacts est coupée quand un arrêt d'urgence est demandé.

La demande de brevet US 2004/0199 837 A1 décrit un procédé et dispositif pour la transmission sécurisée d'informations entre des unités d'entrée et de sortie d'un système de sécurité.

La demande de brevet US 2011/0169345 A1 décrit un système de contrôle interdisant une mise en marche d'une charge quand la commande ou l'alimentation de la charge présentent une anomalie.

La demande de brevet US2019/068088 A1 décrit un circuit de commande basé sur un opto-coupleur ainsi qu'une méthode pour commander le circuit afin d'alimenter une charge.

### Exposé de l'invention

La présente invention a pour objet un dispositif de commande sécurisée selon la revendication 1.

Avantageusement, le dispositif de commande sécurisé présente également une ou plusieurs des caractéristiques des revendications 2 à 8.

La présente invention a également pour objet un contacteur selon la revendication 9. Avantageusement, le contacteur présente également une ou plusieurs caractéristiques de la revendication 10.

La présente invention a également pour objet un procédé de traitement sécurisé d'un troisième signal selon la revendication 11.

Avantageusement, le procédé présente également une ou plusieurs des caractéristiques des revendications 12 à 15.

De préférence, un premier ordre de commande sécurisée d'arrêt est généré quand le second compteur est égal ou supérieur à un seuil d'invalidation prédéfini.

### Brève description des dessins

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
[Fig. 1] la figure 1 représente, sous forme d'un schéma bloc, un dispositif de commande sécurisée selon l'invention,
[Fig. 2ac] les figures 2a et 2b représentent des variantes de réalisation d'un circuit de protection faisant partie du dispositif de commande sécurisée, la figure 2c représente une association d'un circuit de détection de seuil de tension et d'un premier circuit coupleur,
[Fig. 2de] la figure 2d représente une courbe de variation d'un courant circulant dans le circuit de protection , la figure 2e représente une courbe de variation d'un courant circulant dans un premier circuit émetteur,
[Fig. 3] la figure 3 représente, sous forme d'un schéma bloc, une variante de connexion d'un premier interrupteur dans un dispositif de commande sécurisée,
[Fig. 4] la figure 4 représente, sous forme d'un schéma bloc, un dispositif de commande sécurisée comportant une entrée de validation,
[Fig. 5] la figure 5a représente, sous forme d'un schéma bloc, un contacteur comportant un dispositif de commande sécurisée, et la figure 5b représente un contacteur comportant un dispositif de commande sécurisée comportant une entrée de validation,
[Fig. 6ab]

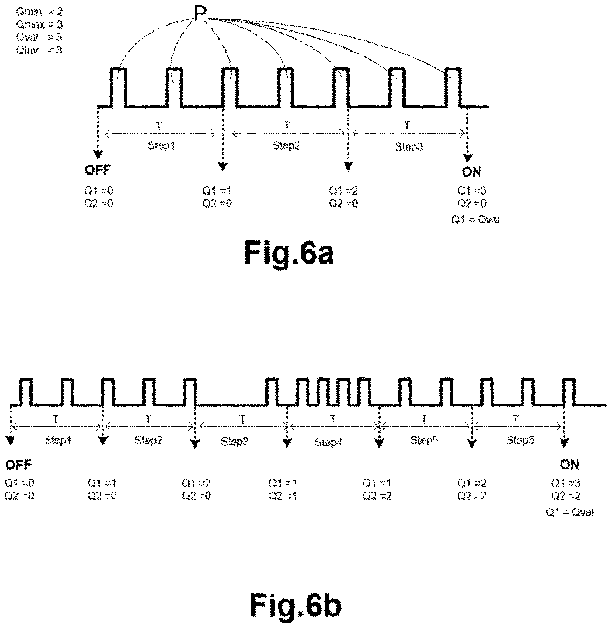

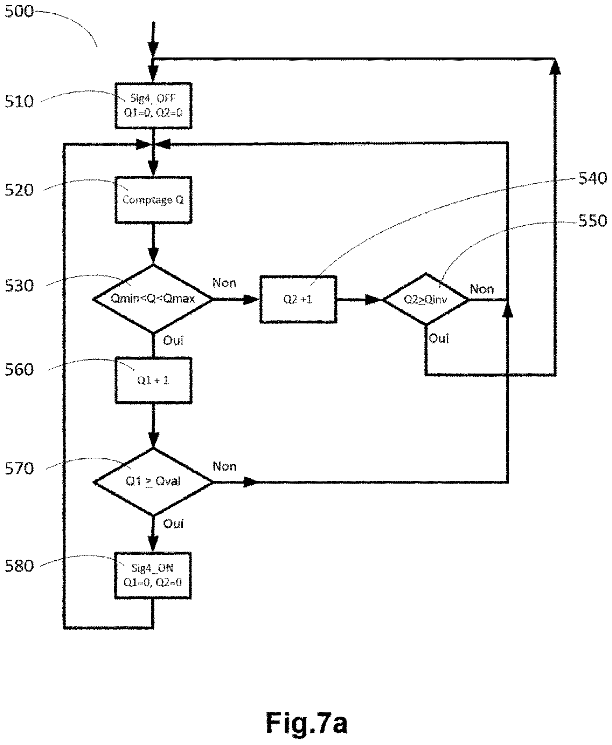

[Fig. 6cd] les figures 6a à 6d sont des représentations temporelles d'un signal reçu par un circuit de traitement faisant partie d'un dispositif de commande sécurisée, [Fig. 7a] la figure 7a représente un organigramme d'un procédé de traitement sécurisé d'un signal effectué par le circuit de traitement, et

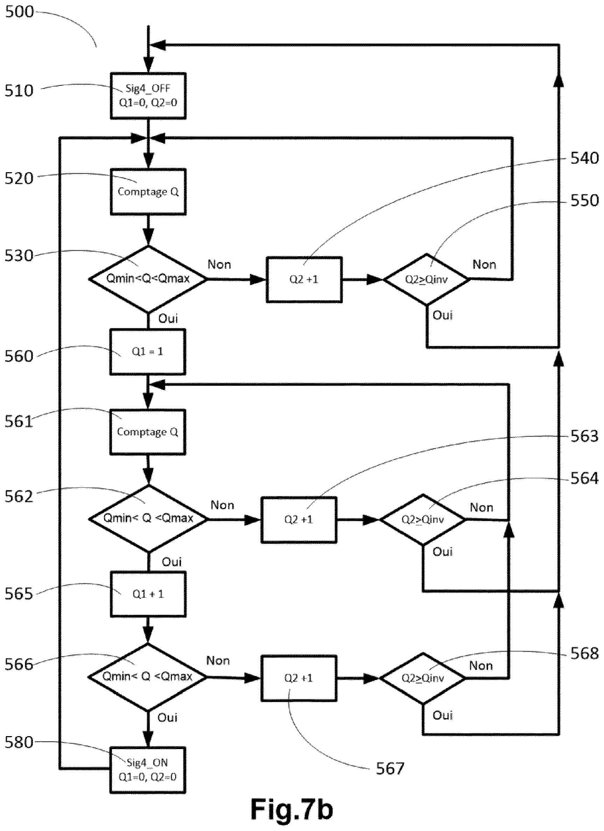

[Fig. 7b] la figure 7b représente un organigramme d'une variante préférentielle du procédé de traitement sécurisé effectué par le circuit de traitement.

### Description détaillée de modes de réalisation préférés

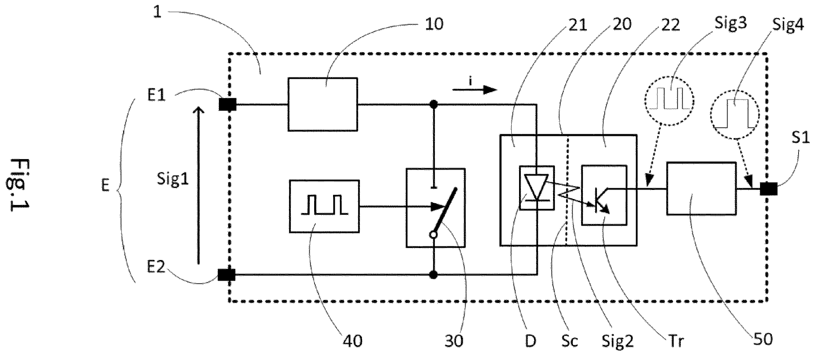

La figure 1 représente, sous forme d'un schéma bloc, un dispositif de commande sécurisée 1 destiné à traiter un signal de commande Sig1 et générer un premier ordre de commande sécurisée. Ledit dispositif de commande sécurisée 1 comprend, au moins :
- une entrée de commande E,
- un premier circuit de protection 10,
- un premier coupleur 20,
- un premier interrupteur 30,
- un générateur d'impulsions 40,
- un premier circuit de traitement 50, et
- une première sortie binaire S1.

L'entrée de commande E comporte au moins un premier point E1 et un deuxième point E2 de connexion. Le signal de commande Sig1 est appliqué entre le premier point E1 et le deuxième point E2. Le signal de commande Sig1 est préférentiellement un échelon ou un niveau de tension continue d'amplitude Vsig1 comprise entre 1 Volt et 30 Volt, préférentiellement d'une durée comprise entre 5 ms et 100 ms.

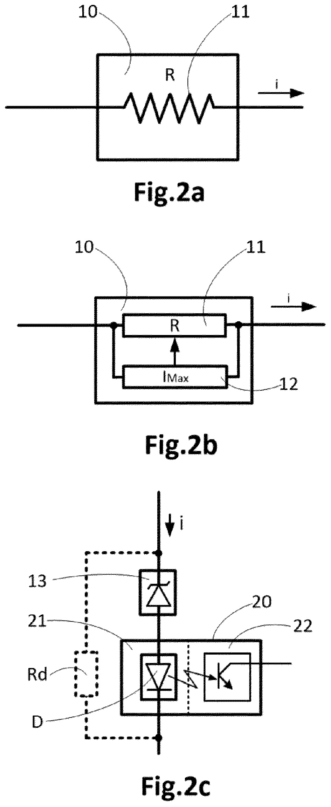

Le premier circuit de protection 10 est agencé pour écrêter le signal de commande Sig1 s'il a une amplitude Vsig1 anormalement élevée et/ou pour limiter un courant i circulant dans le dispositif de commande sécurisée 1, quand un signal de commande Sig1 est appliqué. Un premier mode de réalisation du premier circuit de protection 10 est représenté en figure 2a est comporte un limiteur de courant 11 constitué, par exemple, d'au moins une résistance R. Préférentiellement, la résistance R est dimensionnée pour limiter le courant i à une intensité maximale I_{Max} prédéfinie comprise entre 1 mA et 100 mA.

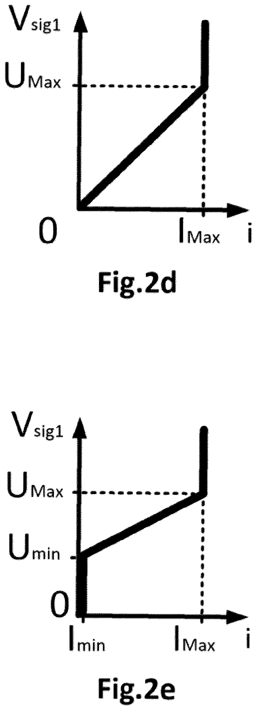

Selon l'invention, le premier circuit de protection 10 comporte un limiteur de courant 11 connecté à un circuit de détection de seuil de courant 12 ainsi que représenté en figure 2b. La figure 2d représente une courbe de variation du courant i circulant dans le premier circuit de protection 10 en fonction de l'amplitude Vsig1 du signal de commande Sig1. Quand l'intensité du courant i est inférieure à l'intensité maximale de courant I_{Max}, le circuit de détection de seuil de courant 12 n'agit pas, le courant i est fixé par le ratio entre l'amplitude Vsig1 du signal de commande Sig1 et la valeur de la résistance R selon la loi d'Ohm. Par exemple, pour une amplitude Vsig1 du signal de commande Sig1 égale à 24 Volt et pour une résistance R égale à 2 000 Ohm, l'amplitude du courant i sera égale à 12 mA. Quand l'amplitude Vsig1 du signal de commande Sig1 dépasse un seuil de tension maximale Uₘₐₓ prédéfini, le circuit de détection de seuil de courant 12 agit sur le limiteur de courant 11 de manière à augmenter la valeur de la résistance R pour maintenir l'intensité du courant i à l'intensité maximale de courant prédéfinie I_{Max}. Ainsi, le courant i étant constant, la puissance dissipée et donc l'échauffement dans le limiteur de courant 11 ne varient que selon une loi linéaire en fonction de l'amplitude Vsig1 du signal de commande Sig1.

Un circuit de détection de seuil de tension 13 est connecté en série avec le premier circuit de protection 10 et avec le premier coupleur 20, ainsi que représenté en figure 2c. Dans cette configuration, le circuit de détection de seuil de tension 13 détecte un seuil de tension minimale Umin prédéfini. Tant que l'amplitude Vsig1 du signal de commande Sig1 est inférieure audit seuil de tension minimale Umin, le circuit de détection de seuil de tension 13 limite le courant i circulant dans un premier circuit émetteur 21 du premier coupleur 20 et à une intensité minimale Iₘᵢₙ prédéfinie. Quand l'amplitude Vsig1 du signal de commande Sig1 est supérieure au seuil de tension minimale Umin, le circuit de détection de seuil de tension 13 est inactif, le courant i est seulement limité par le limiteur de courant 11. Une courbe représentative de la variation du courant i circulant dans le premier circuit de protection 10 en fonction de l'amplitude Vsig1 du signal de commande Sig1 selon un tel mode de fonctionnement est représentée en figure 2e. Un tel circuit de détection de seuil de tension 13 est utilisé afin que le premier coupleur 20 ne reçoive le signal de commande Sig1 que si ledit signal de commande Sig1 possède une amplitude supérieure à la tension minimale Umin afin, par exemple, d'éliminer des signaux parasites. Le circuit de détection de seuil 13 peut être constitué d'au moins une diode zener.

Optionnellement, par exemple pour être en conformité avec les recommandations de la norme IEC60947-1 Annexe S qui traite les entrées digitales pour les appareillages basse tension, une résistance de dérivation Rd est connectée en parallèle sur le circuit de détection de seuil 13 et le premier coupleur 20 ainsi que représenté en figure 2c afin qu'un courant i soit toujours présent même lorsque le premier interrupteur 30 est ouvert et que l'amplitude Vsig1 du signal de commande Sig1 est inférieure à la tension minimale Umin. La résistance de dérivation Rd peut également être connectée en parallèle sur le premier interrupteur 30.

Dans un mode de réalisation préférentiel, le limiteur de courant 11 limite l'amplitude du courant i à une intensité maximale de courant prédéfinie I_{Max} comprise entre 8 mA et 20 mA, l'intensité minimale prédéfinie du courant Imin est comprise entre 0 et 8 mA, le seuil de tension maximale prédéfini U_{Max} est compris entre 12 Volt et 30 Volt, le seuil de tension minimale prédéfini Umin est compris entre 0 et 12 Volt.

Le premier coupleur 20 comporte le premier circuit émetteur 21 connecté en série avec le premier circuit de protection 10, l'ensemble formé par le premier circuit émetteur 21 et le premier circuit de protection 10 étant connecté entre le premier point E1 et le deuxième point E2 de connexion, ainsi que représenté en figure 1. Le premier circuit émetteur 21 est agencé pour émettre un deuxième signal Sig2 quand le signal de commande Sig1 est présent sur l'entrée de commande E et que le courant i circule dans ledit premier circuit émetteur 21. Le premier coupleur 20 comporte également un premier circuit récepteur 22 agencé pour recevoir le deuxième signal Sig2 et pour fournir un troisième signal Sig3. Ledit troisième signal Sig3 est formé d'au moins une impulsion ainsi qu'il sera détaillé ultérieurement. Le premier circuit émetteur 21 et le premier circuit récepteur 22 dudit premier coupleur 20 sont isolés galvaniquement l'un de l'autre.

Préférentiellement, le premier coupleur 20 comporte au moins un optocoupleur : le premier circuit émetteur 21 comporte une diode émettrice D, le premier circuit récepteur 22 comporte un phototransistor Tr, la diode émettrice D émettant un rayonnement vers le phototransistor Tr au travers d'une paroi Sc transparente au rayonnement, ladite paroi étant disposée entre la diode émettrice D et le phototransistor Tr, ledit rayonnement formant un support de transmission du deuxième signal Sig2. Le phototransistor Tr fournit le troisième signal Sig3 à l'image deuxième signal Sig2. La paroi Sc possède également une propriété d'isolant électrique, c'est-à-dire qu'elle ne conduit pas le courant électrique afin de procurer une isolation galvanique entre le premier circuit émetteur 21 et le premier circuit récepteur 22.

Le premier interrupteur 30 est connecté en parallèle sur le premier circuit émetteur 21 pour court-circuiter le premier circuit émetteur 21 lorsque ledit premier interrupteur 30 est fermé. Ainsi, le premier circuit émetteur 21 ne peut émettre que lorsque le premier interrupteur 30 est dans un état ouvert. Le premier interrupteur 30 est préférentiellement un transistor bipolaire ou à effet de champ. Cette configuration présente l'avantage de garantir une circulation constante d'un courant i dès qu'un signal de commande Sig1 est présent sur l'entrée de commande E, quel que soit l'état ouvert ou fermé du premier interrupteur 30. Le premier interrupteur 30 est commandé par le générateur d'impulsions 40.

Le générateur d'impulsions 40 est connecté au premier interrupteur 30 et génère des impulsions pour commander cycliquement une ouverture et une fermeture du premier interrupteur 30. De préférence, une impulsion commande une fermeture du premier interrupteur 30, le premier interrupteur 30 étant ouvert pendant l'intervalle de temps entre deux impulsions consécutives. Le signal de commande Sig1 est donc modulé par les impulsions délivrées par le générateur d'impulsions 40.

Le générateur d'impulsions 40 génère des impulsions préférentiellement de forme rectangulaire, ayant un rapport cyclique prédéfini, inférieur ou égal à 50%, de fréquence comprise de préférence entre 100 Hz et 10 kHz. Préférentiellement le générateur d'impulsions 40 est un oscillateur libre, non synchronisé avec un quelconque autre signal présent dans le dispositif de commande sécurisée 1.

En présence d'un signal de commande Sig1, la diode émettrice D du premier circuit émetteur 21 émet un rayonnement vers le phototransistor Tr du premier circuit récepteur 22 quand le premier interrupteur 30 est ouvert. Ledit phototransistor Tr fournit alors une impulsion formant le troisième signal Sig3, tel que représenté en figure 6a. Quand le premier interrupteur 30 est fermé, le premier circuit émetteur 21 n'émet plus de rayonnement vers le phototransistor Tr, le troisième signal Sig3 devient nul. Ainsi, le troisième signal Sig3 comporte au moins une impulsion P quand le signal de commande Sig1 est présent et que le générateur d'impulsion 40 génère des impulsions.

Le premier circuit de traitement 50 est connecté au premier circuit récepteur 22 pour recevoir le troisième signal Sig3. Ledit premier circuit de traitement 50 est agencé pour exécuter un procédé de traitement sécurisé 500 décrit ultérieurement afin de traiter le troisième signal Sig3 et fournir un premier ordre de commande sécurisée Sig4. Ledit premier ordre de commande sécurisée Sig4 peut prendre, au moins, deux états :
- un premier ordre de commande sécurisée de marche Sig4_ON, ou
- un premier ordre de commande sécurisée d'arrêt Sig4_OFF.

Le premier ordre de commande sécurisée de marche Sig4_ON correspond à une commande sécurisée de mise en marche, le premier ordre de commande sécurisée d'arrêt Sig4_OFF correspond à une commande sécurisée d'arrêt, particulièrement adaptée à un ordre sécurisé d'arrêt d'urgence.

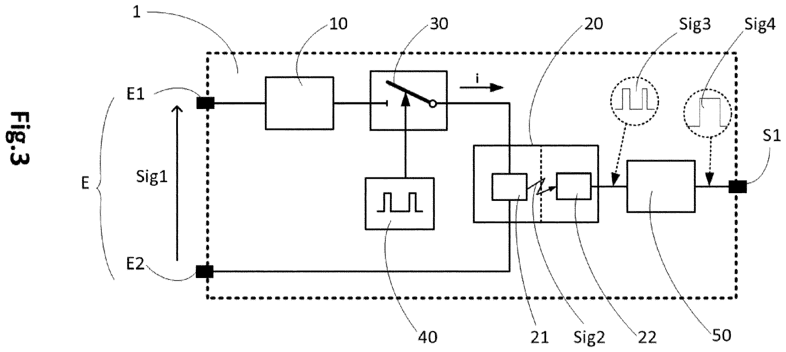

Selon une variante de connexion du premier circuit interrupteur 30, ledit premier interrupteur 30 est connecté en série avec le premier circuit de protection 10 et le premier circuit émetteur 21 ainsi que représenté en figure 3. Dans ce cas, le troisième signal Sig3 est formé d'impulsions P quand le signal de commande Sig1 est présent sur l'entrée E et que le premier interrupteur 30 est fermé. Le traitement effectué par le premier circuit de traitement 50 sur le troisième signal Sig3 est inchangé.

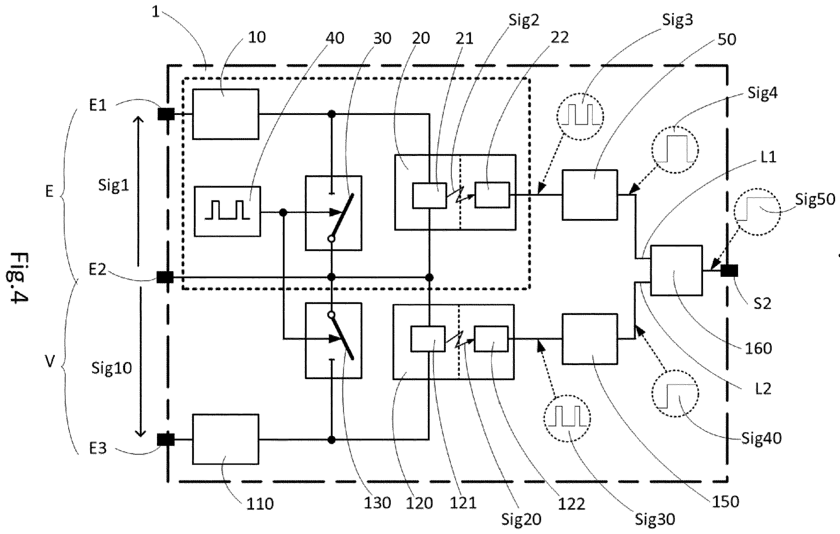

Il est souvent demandé une implantation d'une double commande sécurisée dans une installation de sureté. Une telle double commande comporte une première commande sécurisée ayant un rôle de commande de marche et une seconde commande sécurisée ayant un rôle de validation ou d'autorisation et dont l'absence correspond généralement à une commande d'arrêt d'urgence. Pour répondre à ce besoin, l'invention porte également sur un dispositif de commande sécurisée 1, représenté en figure 4, comportant un dispositif de commande sécurisé 1 tel que décrit précédemment, et comportant, en outre :
- une entrée de validation V comportant un troisième point de connexion E3, ladite entrée de validation V étant agencée pour recevoir un signal de validation Sig 1 0 appliqué entre le deuxième point de connexion E2 et ledit troisième point de connexion E3,
- un second circuit de protection 110,
- un second coupleur 120 comportant :
   - un second circuit émetteur 121 connecté en série avec le second circuit de protection 110, l'ensemble formé par le second circuit émetteur 121 et le second circuit de protection 110 étant connecté entre le troisième point de connexion E3 et le deuxième point de connexion E2, ledit second circuit émetteur 121 étant agencé pour émettre un quatrième signal Sig20 quand le signal de validation Sig10 est présent sur l'entrée de validation V, et
   - un second circuit récepteur 122 agencé pour recevoir le quatrième signal Sig20 et pour fournir un cinquième signal Sig30,
- un second interrupteur 130 connecté, d'une part, en parallèle sur le second circuit émetteur 121 pour court-circuiter ledit second émetteur 121 lorsqu'il est fermé, et connecté d'autre part au générateur d'impulsions 40 pour que ledit générateur d'impulsions 40 commande cycliquement une ouverture et une fermeture dudit second interrupteur 130,
- un second circuit de traitement 150 connecté au second circuit récepteur 122 pour recevoir le cinquième signal Sig30 ledit second circuit de traitement 150 étant agencé pour traiter le cinquième signal Sig30 et fournir un deuxième ordre de commande sécurisée Sig40 pouvant prendre, au moins, deux états :
   - un deuxième ordre de commande sécurisée de marche Sig40_ON, et
   - un deuxième ordre de commande sécurisée d'arrêt Sig40_OFF, et
- un circuit logique 160 comportant :
   - une première entrée binaire L1 connectée au premier circuit de traitement 50 pour recevoir le premier ordre de commande sécurisée Sig4,
   - une seconde entrée binaire L2 connectée au second circuit de traitement 150 pour recevoir le deuxième ordre de commande sécurisée Sig40, et
   - une seconde sortie binaire S2 pour fournir un troisième ordre de commande sécurisée Sig50.

Le troisième ordre de commande sécurisée Sig50 peut prendre, au moins, deux états :
- un troisième ordre de commande sécurisée de marche Sig50_ON quand le premier ordre de commande sécurisée Sig4 fournit par le dispositif de commande sécurisé 1 est un premier ordre de commande sécurisée de marche Sig4_ON et quand le deuxième ordre de commande sécurisée Sig40 est un deuxième ordre de commande sécurisée de marche Sig40_ON, ou alors
- un troisième ordre de commande sécurisée d'arrêt Sig50_OFF quand le premier ordre de commande sécurisée Sig4 fournit par le dispositif de commande sécurisé 1 est un premier ordre de commande sécurisée d'arrêt Sig4_OFF ou que le deuxième ordre de commande sécurisée Sig40 est un deuxième ordre de commande sécurisée d'arrêt Sig40_OFF.

Le troisième ordre de commande sécurisée de marche Sig50_ON est donné quand le premier ordre de commande sécurisée de marche Sig4_ON et le deuxième ordre de commande sécurisée Sig40 sont fournis respectivement par les premier et second circuits de traitement 50, 150. Le troisième ordre de commande sécurisée d'arrêt Sig50_OFF est fourni :
- quand le premier ordre de commande sécurisée d'arrêt Sig4_OFF est fourni par le premier circuit de traitement 50, ou
- quand le deuxième ordre de commande sécurisée d'arrêt Sig40_OFF est fourni par le second circuit de traitement 150.

Le second circuit de protection 110 est semblable au premier circuit de protection 10,
le second coupleur 120 est semblable au premier coupleur 20,
le second interrupteur 130 est semblable au premier interrupteur 30, et
le second circuit de traitement 150 est semblable au premier circuit de traitement 50.

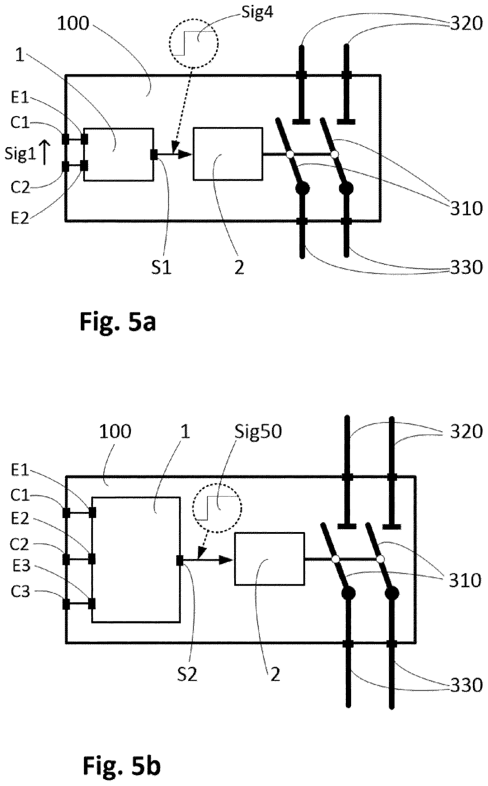

L'invention concerne également un contacteur 100 représenté sous forme d'un schéma bloc en figure 5a. Ledit contacteur 100 comporte :
- au moins un contact électrique 310 connecté à, au moins, une ligne de courant amont 320 et une ligne de courant aval 330, ledit contact électrique 310 étant agencé pour permettre le passage ou l'arrêt de la circulation d'un courant électrique entre la ligne de courant amont 320 et la ligne de courant aval 330,
- un actionneur 2 agencé pour actionner le, au moins un, contact électrique 310,
- un dispositif de commande sécurisée 1 tel que décrit précédemment,
- une première borne de raccordement C1 connectée au premier point de connexion E1 dudit dispositif de commande sécurisée 1, et
- une deuxième borne de raccordement C2 connectée au deuxième point de connexion E2 dudit dispositif de commande sécurisée 1, le signal de commande Sig1 étant appliqué entre la première borne de raccordement C1 et la deuxième borne de raccordement C2. Le dispositif de commande sécurisée 1 reçoit ainsi le signal de commande Sig1 sur son entrée de commande sécurisé E.

Le dispositif de commande sécurisée est connecté via la première sortie binaire S1 à l'actionneur 2 pour fournir un premier ordre de commande sécurisée Sig4 audit actionneur 2 afin de commander un actionnement du, au moins un, contact électrique 310 quand le signal de commande Sig1 est reçu sur son entrée de commande sécurisé E. Le dispositif de commande sécurisée 1 commande l'actionneur 2 :
- pour exécuter une fermeture du, au moins un, contact électrique 310 quand le premier ordre de commande sécurisée Sig4 est un premier ordre de commande sécurisée de marche Sig4_ON, ou
- pour exécuter une ouverture du, au moins un, contact électrique 310 quand le premier ordre de commande sécurisée Sig4 est un premier ordre de commande sécurisée d'arrêt Sig4_OFF.

Selon un mode de réalisation préférentiel, le contacteur 100, représenté, sous forme d'un schéma bloc en figure 5b, comporte, en outre, une troisième borne de raccordement C3 connectée au troisième point de connexion E3 du dispositif de commande sécurisée 1. Le signal de validation Sig10 est appliqué entre la deuxième borne de raccordement C2 et ladite troisième borne de raccordement C3.

Un tel contacteur 100 comporte deux entrées de commande sécurisée : un signal de commande Sig1, appliqué entre la première et la deuxième borne de raccordement, respectivement C1 et C2, reçu sur l'entrée de commande E du dispositif de commande sécurisée 1, correspond à une commande de marche. Un signal de validation Sig10, appliqué entre la deuxième borne de raccordement C2 et la troisième borne de raccordement C3, reçu sur l'entrée de validation V du dispositif de commande sécurisée 1, correspond à une validation ou autorisation d'une commande portée par le signal de commande Sig1. Une absence dudit signal de validation Sig10 correspond à une demande d'arrêt d'urgence. Le signal de validation Sig10 est préférentiellement un échelon ou un créneau de tension continue d'amplitude comprise entre 1 Volt et 30 Volt.

Le dispositif de commande sécurisée 1 est connecté à l'actionneur via une seconde sortie binaire S2 pour fournir à l'actionneur 2 un troisième ordre de commande sécurisée Sig50, ledit troisième ordre de commande sécurisée Sig50 pouvant prendre deux états, ainsi que décrit précédemment :
- un troisième ordre de commande sécurisée de marche Sig50_ON, ou
- un troisième ordre de commande sécurisée d'arrêt Sig50_OFF.

Ledit contacteur 100 est agencé de façon à ce que :
- le dispositif de commande sécurisée 1 fournit un troisième ordre de commande sécurisée de marche Sig50_ON à l'actionneur 2 pour commander à l'actionneur 2 l'exécution d'une fermeture d'au moins un contact électrique 310 quand le premier ordre de commande sécurisée Sig4 est un premier ordre de commande de marche Sig4_ON et que le deuxième ordre de commande sécurisée Sig40 est un deuxième ordre de commande sécurisée de marche Sig40_ON, ou
- le dispositif de commande sécurisée 1 fournit un troisième ordre de commande sécurisée d'arrêt Sig50_OFF à l'actionneur 2 pour commander à l'actionneur 3 l'exécution d'une ouverture d'au moins un contact électrique 310 quand le premier ordre de commande sécurisée Sig4 est un premier ordre de commande d'arrêt Sig4_OFF ou que le deuxième ordre de commande sécurisée Sig40 est un deuxième ordre de commande d'arrêt Sig40_OFF.

Ainsi le signal de commande Sig1 est validé quand le premier circuit de traitement 50 a validé la conformité du signal de commande Sig1 et quand le second circuit de traitement 150 a validé la conformité du signal de validation Sig10. Si l'un des signaux de commande Sig1 ou de validation Sig10 n'est pas conforme, alors le contacteur 100 sera mis dans un état de sécurité correspondant à une ouverture d'au moins un contact électrique 310 pour mettre en sécurité le personnel et empêcher ou limiter des dégâts matériels.

D'autres modes de fonctionnement du contacteur 100 sont possibles, en particulier un mode dans lequel le signal de commande Sig1 est un signal impulsionnel, de durée limitée et le signal de validation Sig10 a un rôle d'autorisation / validation de ladite commande de fermeture de l'actionneur 2. Le signal de validation Sig10 est appliqué en premier ou simultanément avec le signal de commande Sig1 à la suite de quoi l'actionneur 2 est actionné, au moins un contact électrique 310 est fermé. Ledit actionneur 2 reste ensuite actionné bien que le signal de commande Sig1 ait disparu. En revanche, dès que le signal de validation Sig10 disparait, l'actionneur 2 est désactivé, au moins un contact électrique 310 est ouvert. Un tel fonctionnement peut être mis en oeuvre aisément par le circuit logique 160.

Un contacteur 100 peut comporter un seul contact électrique 310 connecté entre une ligne de courant amont 320 et une ligne de courant aval 330, ou encore deux contacts électriques 310 connectés entre deux lignes de courant amont 320 et deux lignes de courant aval 330, les deux contacts électriques 310 étant isolés entre eux, les lignes de courant amont 320 et les lignes de courant aval 330 étant également isolées entre elles ainsi que représenté en figures 5a et 5b. Un contacteur 100 peut également être agencé pour fonctionner sur un réseau triphasé et comporter trois contacts électriques 310, trois lignes de courant amont 320 et trois lignes de courant aval 330.

Le premier circuit de traitement 50 exécute le procédé de traitement sécurisé 500 pour traiter le troisième signal Sig3 et générer le premier ordre de commande sécurisée Sig4. Le second circuit de traitement 150 exécute également et de façon similaire, le procédé de traitement sécurisé 500 pour traiter le cinquième signal Sig30 et générer le deuxième ordre de commande sécurisée Sig40. En conséquence, seul le procédé de traitement sécurisé 500 effectué par le premier circuit de traitement 50 est détaillé ci-après.

Le procédé de traitement sécurisé 500 comporte un comptage itératif d'une quantité Q d'impulsions P formant le troisième signal Sig3, lesdites impulsions P étant fournies par le premier circuit récepteur 22 pendant un intervalle de temps de durée prédéfinie T, ainsi que représenté par la figure 6a.

Un premier mode de réalisation du procédé de traitement sécurisé 500 est représenté en figure 7a. Au cours d'une étape d'initialisation 510, un premier ordre de commande sécurisée d'arrêt Sig4_OFF est émis afin d'initialiser le premier ordre de commande sécurisée Sig4. Un premier compteur Q1 et un second compteur Q2 sont également initialisés. Ensuite, au cours d'une étape de comptage 520, le procédé effectue un comptage Q du nombre d'impulsions P reçues au cours d'un intervalle de temps prédéfini T. A la fin de l'étape de comptage 520 a lieu une étape 530 de comparaison du nombre Q d'impulsions comptées par rapport à nombre minimum d'impulsions Qmin prédéfini et un nombre maximum d'impulsions Qmax prédéfini. Quand le nombre Q d'impulsions comptées est en dehors de l'intervalle entre le nombre minimum d'impulsions Qmin et le nombre maximum d'impulsions Qmax alors le procédé se poursuit par une étape 540 d'incrémentation du second compteur Q2. Le second compteur Q2 est comparé ensuite à un seuil d'invalidation Qinv prédéfini au cours d'une étape 550. Quand le second compteur Q2 est égal ou supérieur au seuil d'invalidation Qinv, le procédé considère que le nombre Q d'impulsions comptées n'est pas conforme et le procédé retourne à l'étape d'initialisation 510 correspondant à un état de sécurité et en particulier le premier ordre de commande sécurisée d'arrêt Sig4_OFF est généré. En revanche, quand le nombre Q d'impulsions comptées est à l'intérieur de l'intervalle entre le nombre minimum d'impulsions Qmin et le nombre maximum d'impulsions Qmax alors le procédé se poursuit par une étape 560 d'incrémentation du premier compteur Q1. Ensuite, au cours d'une étape 570, le premier compteur Q1 est comparé à un seuil de validation Qval prédéfini. Quand le premier compteur Q1 est inférieur audit seuil de validation Qval, alors le procédé retourne à l'étape de comptage 520 pour exécuter une itération supplémentaire. Quand le premier compteur Q1 est supérieur ou égal au seuil de validation Qval, le procédé se poursuit par une étape 580 comportant une génération du premier ordre de commande sécurisée de marche Sig4_ON et une réinitialisation des premier et second compteurs Q1 et Q2. Le procédé retourne ensuite à l'étape de comptage 520 pour exécuter une nouvelle itération.

Un second mode de réalisation du procédé de traitement sécurisé 500 est représenté en figure 7b. Les étapes d'initialisation 510, de comptage 520, de comparaison 530, d'incrémentation du second compteur Q2 lors de l'étape 540, de comparaison au seuil d'invalidation à l'étape 550 et d'incrémentation du premier compteur Q1 à l'étape 560 sont identiques. En revanche après ladite étape 560 d'incrémentation du premier compteur Q1, une seconde étape de comptage 561 est effectuée, suivie d'une étape 562 de comparaison du nombre Q d'impulsions comptées par rapport au nombre minimum d'impulsions Qmin et au nombre maximum d'impulsions Qmax. Quand le nombre Q d'impulsions comptées est inférieur au nombre minimum d'impulsions Qmin ou supérieur au nombre maximum d'impulsions Qmax alors le procédé se poursuit par une étape 563 d'incrémentation du second compteur Q2, ledit second compteur Q2 étant comparé ensuite au seuil d'invalidation Qinv au cours d'une étape 564. Quand le second compteur Q2 est égal ou supérieur au seuil d'invalidation Qinv, le procédé considère que le nombre Q d'impulsions comptées n'est pas conforme et le procédé retourne à l'étape d'initialisation 510 correspondant à un état de sécurité. Quand le second compteur Q2 est inférieur au seuil d'invalidation Qinv, le procédé retourne à la seconde étape de comptage 561. Quand le nombre Q d'impulsions comptées à l'étape 562 est compris entre le nombre minimum d'impulsions Qmin et le nombre maximum d'impulsions Qmax alors le procédé se poursuit par une étape 565 d'incrémentation du premier compteur Q1 et une nouvelle boucle de contrôle du nombre Q d'impulsions P reçues pendant un intervalle de temps T au cours des étapes de comparaison 566, d'incrémentation 567 et de comparaison 568. En particulier, à l'étape de comparaison 568, quand le second compteur Q2 est inférieur au seuil d'invalidation Qinv, le procédé retourne à la seconde étape de comptage 561. Le second mode de réalisation du procédé de traitement sécurisé 500 ainsi décrit nécessite que la quantité Q d'impulsions P comptées au cours de deux intervalles de temps T successifs soit à l'intérieur de l'intervalle entre le nombre minimum d'impulsions Qmin et le nombre maximum d'impulsions Qmax. Ledit second mode est donc plus exigeant que le premier mode de réalisation du procédé représenté en figure 7a, il est mieux adapté à une mise en oeuvre en milieu industriel soumis à des perturbations électromagnétiques importantes. D'autres variantes de méthode de comptage du nombre d'impulsions Q et de critère de décision pour générer le premier ordre de commande sécurisée peuvent être construites sur la base des procédés décrits précédemment afin d'adapter le procédé à des environnements particuliers.

Préférentiellement, le nombre minimum d'impulsions Qmin est compris entre 2 et 5, le nombre maximum d'impulsions Qmax est compris entre 3 et 50, le seuil de validation Qval est compris entre 2 et 10, le seuil d'invalidation Qinv est compris entre 2 et 5, la durée de l'intervalle de temps T est comprise entre 1 ms et 10 ms. La figure 6b illustre, au moyen d'une représentation temporelle, un exemple de comptage d'une quantité Q d'impulsions P formant le troisième signal Sig3 et l'évolution des premier et second compteurs Q1 et Q2 au cours du temps. Dans cet exemple, Qmin = 2, Qmax = 3, Qval = 3, Qinv = 3. A l'instant initial, les premier et second compteurs Q1 et Q2 sont initialisés à zéro. Au cours d'un premier intervalle de temps T, correspondant à une première itération STEP1, deux impulsions P sont comptées, donc Q = 2, le premier compteur Q1 s'incrémente, Q1 = 1, puisque Q est compris entre Qmin et Qmax. Lors de la période T suivante correspondant à l'itération STEP2, trois impulsions P sont comptées, donc le premier compteur Q1 s'incrémente une fois de plus, Q1 = 2. Lors de la période T suivante correspondant à l'itération STEP3, une seule impulsions P est comptée, donc Q=1. Le premier compteur Q1 n'est pas incrémenté puisque le nombre Q d'impulsions comptées est en dehors de l'intervalle entre le nombre minimum d'impulsions Qmin et le nombre maximum d'impulsions Qmax, ainsi que vérifié à l'étape de comparaison 530. En revanche, le second compteur Q2 est incrémenté. Lors de la période T suivante correspondant à l'itération STEP4, quatre impulsions P sont comptées, le premier compteur Q1 n'est pas incrémenté alors que le second compteur Q2 est incrémenté puisque le nombre Q d'impulsions comptées est en dehors de l'intervalle entre le nombre minimum d'impulsions Qmin et le nombre maximum d'impulsions Qmax. Lors de la période T suivante correspondant à l'itération STEP5, deux impulsions sont comptées, le premier compteur Q1 est incrémenté et prend la valeur 2. Lors de la période T suivante correspondant à l'itération STEP6, le premier compteur Q1 est incrémenté puisqu'on compte deux impulsions P au cours de la période T. Le premier compteur Q1 atteint la valeur 3 correspondant au seuil de validation Qval choisi dans cet exemple, la commande est donc sécurisée, un premier ordre de commande sécurisée de marche Sig4_ON est émis, les premier et second compteurs Q1 et Q2 sont réinitialisés à zéro et le procédé revient à l'étape de comptage 520 pour exécuter une nouvelle itération.

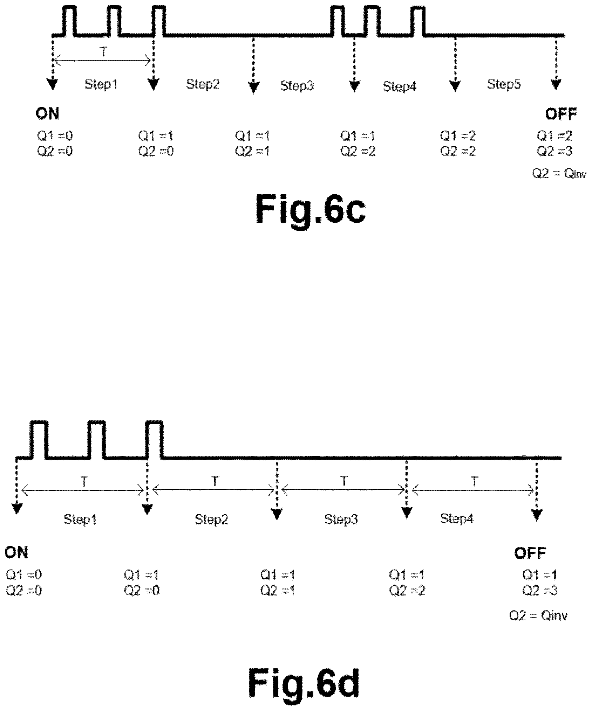

La figure 6c illustre un second exemple de comptage d'une quantité Q d'impulsions P formant le troisième signal Sig3 et l'évolution des premier et second compteurs Q1 et Q2 au cours du temps. A l'instant initial, les premier et second compteurs Q1 et Q2 sont à zéro. Au cours d'un premier intervalle de temps T, correspondant à une première itération STEP1, deux impulsions P sont comptées, donc le premier compteur Q1 est incrémenté. Lors de la période T suivante correspondant à l'itération STEP2, une seule impulsions P est comptée. Le premier compteur Q1 n'est pas incrémenté en revanche le second compteur Q2 est incrémenté puisque le nombre Q d'impulsions comptées est en dehors de l'intervalle entre le nombre minimum d'impulsions Qmin et le nombre maximum d'impulsions Qmax. Il en est de même lors de la période T suivante correspondant à l'itération STEP3 puisqu'une seule impulsions P est comptée, le second compteur Q2 est égal à 2. Au cours de la période T suivante, correspondant à l'itération STEP4, deux impulsions P sont comptées, le premier compteur Q1 est incrémenté, donc Q1 = 2. Lors de la période T suivante correspondant à l'itération STEP5, il n'y a aucune impulsion P, le second compteur Q2 est incrémenté et atteint la valeur 3 égale au seuil d'invalidation Qinv choisi dans cet exemple. La commande sécurisée est donc invalidée, le procédé retourne à l'étape d'initialisation 510 correspondant à un état de sécurité. Le premier ordre de commande sécurisée d'arrêt Sig4_OFF est généré, les premier et second compteurs Q1 et Q2 sont réinitialisés à zéro et le procédé se poursuit à l'étape de comptage 520 pour exécuter une nouvelle itération.

La figure 6d illustre un troisième exemple dans lequel le nombre d'impulsions Q comptées au cours de 3 itérations STEP2, STEP3 et STEP4 est égal à 0. Le second compteur Q2 atteint alors la valeur 3 à la fin de l'itération STEP4 et le premier ordre de commande sécurisée d'arrêt Sig4_OFF est généré. Cet exemple illustre un fonctionnement d'une commande d'arrêt d'urgence sécurisée.

Ainsi le premier compteur Q1 comptabilise le nombre d'itérations STEP1, STEP2, STEP3, etc. au cours desquelles la quantité Q d'impulsions P est dans l'intervalle de valeurs attendues, le second compteur Q2 comptabilise le nombre d'itérations STEP1, STEP2, STEP3, etc. au cours desquelles la quantité Q d'impulsions P est en dehors de l'intervalle de valeurs attendues. Le temps de réponse d'un tel procédé permet de valider un ordre de commande sécurisée dans un délai supérieur ou égal à (Qval x T) après le début de l'apparition du troisième signal Sig3. Par exemple, quand Qval = 3 et T = 3ms, le temps de réponse est supérieur ou égal à 9 ms que ce soit pour un premier ordre de commande sécurisée de marche ou un premier ordre de commande d'arrêt.

Le dispositif de commande sécurisée 1 et le procédé de traitement sécurisé faisant l'objet de l'invention contribuent au contrôle et à la validation d'une commande de marche ou d'arrêt d'un contacteur afin, d'une part, d'éviter toute commande intempestive initialisée, par exemple, par des perturbations électromagnétiques et, d'autre part, d'exécuter avec fiabilité une demande d'arrêt d'urgence. De plus, une isolation galvanique entre entrées et sorties est apportée par le premier et le second coupleur. Enfin, la mise en oeuvre d'au moins un premier interrupteur 30 associé à un générateur d'impulsions 40 permet un autocontrôle des circuits composant le dispositif de commande sécurisée 1 ou le dispositif de commande sécurisée 1. De tels circuits de commande sécurisée et le procédé de traitement sécurisé qu'ils comportent peuvent également être mis en oeuvre pour une télécommande de disjoncteur ou de tout autre organe de sécurité. Ils sont particulièrement adaptés aux installations nécessitant une qualification SIL1.

## Revendications

1. Dispositif de commande sécurisée (1) destiné à traiter un signal de commande (Sig1) et générer un premier ordre de commande sécurisée (Sig4), ledit dispositif de commande sécurisée (1) comprenant :
- une entrée de commande (E) comportant au moins un premier point de connexion (E1) et un deuxième point de connexion (E2), ladite entrée de commande (E) étant agencée pour recevoir le signal de commande (Sig1),
- un premier circuit de protection (10),
- un premier coupleur (20) comportant :
- un premier circuit émetteur (21) connecté en série avec le premier circuit de protection (10), l'ensemble formé par le premier circuit émetteur (21) et le premier circuit de protection (10) étant connecté entre le premier point de connexion (E1) et le deuxième point de connexion (E2), ledit premier circuit émetteur (21) étant agencé pour émettre un deuxième signal (Sig2) quand le signal de commande (Sig1) est présent sur l'entrée de commande (E), et
- un premier circuit récepteur (22) agencé pour recevoir le deuxième signal (Sig2) et pour fournir un troisième signal (Sig3) formé d'au moins une impulsion (P),
- un premier interrupteur (30) connecté en parallèle sur le premier circuit émetteur (21),
- un générateur d'impulsions (40) connecté au premier interrupteur (30) et agencé pour commander cycliquement une ouverture et une fermeture du premier interrupteur (30), et
- un premier circuit de traitement (50) connecté au premier circuit récepteur (22) pour recevoir le troisième signal (Sig3), ledit premier circuit de traitement (50) étant agencé pour traiter le troisième signal (Sig3) et fournir le premier ordre de commande sécurisée (Sig4), ledit premier ordre de commande sécurisée (Sig4) pouvant prendre, au moins, deux états :
- un premier ordre de commande sécurisée de marche (Sig4_ON), ou
- un premier ordre de commande sécurisée d'arrêt (Sig4_OFF),
le premier circuit de protection (10) comportant un circuit limiteur de courant (11) pour limiter le courant (i) circulant à travers ledit circuit de protection (10), **caractérisé en ce que** le premier circuit de protection comporte un circuit de détection de seuil de courant (12) connecté au circuit limiteur de courant (11) pour limiter le courant (i) circulant à travers ledit circuit de protection (10) à une intensité maximale prédéfinie (I_{Max}) quand l'amplitude (V_{sig1}) du signal de commande (Sig1) est supérieure à un seuil de tension maximale prédéfini (U_{Max}), et **en ce qu'**un circuit de détection de seuil de tension (13) est connecté en série avec le premier circuit de protection (10) et le premier circuit émetteur (21) pour limiter le courant (i) circulant à travers ledit circuit émetteur (21) à une intensité minimale prédéfinie (Iₘᵢₙ) quand l'amplitude (V_{sig1}) du signal de commande (Sig1) est inférieure à un seuil de tension minimal prédéfini (Uₘᵢₙ).

2. Dispositif de commande sécurisée (1) selon la revendication 1, **caractérisé en ce que** le premier circuit émetteur (21) et le premier circuit récepteur (22) sont isolés galvaniquement l'un de l'autre.

3. Dispositif de commande sécurisée (1) selon l'une des revendications 1 ou 2, **caractérisé en ce que** le premier coupleur (20) comporte au moins un optocoupleur, le premier circuit émetteur (21) comportant une diode émettrice (D) et le premier circuit récepteur (22) comportant un phototransistor (Tr), la diode émettrice (D) émettant un rayonnement formant un support de transmission du deuxième signal (Sig2) vers le phototransistor (Tr) au travers d'une paroi (Sc) transparente au rayonnement et isolante électriquement.

4. Dispositif de commande sécurisée (1) selon l'une quelconque des revendications précédentes, **caractérisé en ce que** le générateur d'impulsions (40) génère des impulsions ayant un rapport cyclique prédéfini, inférieur ou égal à 50%.

5. Dispositif de commande sécurisée (1) selon l'une quelconque des revendications précédentes, **caractérisé en ce que** le générateur d'impulsions (40) génère des impulsions à une fréquence comprise entre 100 Hz et 10 kHz.

6. Dispositif de commande sécurisée (1) selon l'une quelconque des revendications précédentes, **caractérisé en ce que** le premier interrupteur (30) est connecté en série avec le premier circuit de protection (10).

7. Dispositif de commande sécurisée (1) selon l'une quelconque des revendications précédentes, **caractérisé en ce qu'**il comporte, en outre :
- une entrée de validation (V) comportant un troisième point de connexion (E3), ladite entrée de validation (V) étant agencée pour recevoir un signal de validation (Sig10),
- un second circuit de protection (110),
- un second coupleur (120) comportant :
- un second circuit émetteur (121) connecté en série avec le second circuit de protection (110), l'ensemble formé par le second circuit émetteur (121) et le second circuit de protection (110) étant connecté entre le troisième point de connexion (E3) et le deuxième point de connexion (E2) du dispositif de commande sécurisé (1), ledit second circuit émetteur (121) étant agencé pour émettre un quatrième signal (Sig20) quand le signal de validation (Sig10) est présent sur l'entrée de validation (V), et
- un second circuit récepteur (122) agencé pour recevoir le quatrième signal (Sig20) et pour fournir un cinquième signal (Sig30),
- un second interrupteur (130) connecté, d'une part, en parallèle sur le second circuit émetteur (121), et connecté d'autre part au générateur d'impulsions (40) pour que ledit générateur d'impulsions (40) commande cycliquement une ouverture et une fermeture dudit second interrupteur (130),
- un second circuit de traitement (150) connecté au second circuit récepteur (122) pour recevoir le cinquième signal (Sig30) ledit second circuit de traitement (150) étant agencé pour traiter le cinquième signal (Sig30) et fournir un deuxième ordre de commande sécurisée (Sig40), ledit deuxième ordre de commande sécurisée (Sig40) pouvant prendre, au moins, deux états :
- un deuxième ordre de commande sécurisée de marche (Sig40_ON) et
- un deuxième ordre de commande sécurisée d'arrêt (Sig40_OFF),
- un circuit logique (160) comportant :
- une première entrée binaire (L1) connectée au premier circuit de traitement (50) pour recevoir le premier ordre de commande sécurisée (Sig4),
- une seconde entrée binaire (L2) connectée au second circuit de traitement (150) pour recevoir le deuxième ordre de commande sécurisée (Sig40), et
- une seconde sortie binaire (S2) pour fournir un troisième ordre de commande sécurisée (Sig50).

8. Dispositif de commande sécurisée (1) selon l'une quelconque des revendications précédentes **caractérisé en ce que** le troisième ordre de commande sécurisée (Sig50) prend, au moins, deux états :
- un troisième ordre de commande sécurisée de marche (Sig50_ON) quand un premier ordre de commande sécurisée (Sig4) fournit par le dispositif de commande sécurisé (1) est un premier ordre de commande sécurisée de marche (Sig4_ON) et quand le deuxième ordre de commande sécurisée (Sig40) est un deuxième ordre de commande sécurisée de marche (Sig40_ON), ou
- un troisième ordre de commande sécurisée d'arrêt (Sig50_OFF) quand un premier ordre de commande sécurisée (Sig4) fournit par le dispositif de commande sécurisé (1) est un premier ordre de commande sécurisée d'arrêt (Sig4_OFF) ou que le deuxième ordre de commande sécurisée (Sig40) est un deuxième ordre de commande sécurisée d'arrêt (Sig40_OFF).

9. Contacteur (100) comportant :
- au moins un contact électrique (310) connecté à une ligne de courant amont (320) et une ligne de courant aval (330), ledit contact électrique (310) étant agencé pour permettre le passage ou l'arrêt de la circulation d'un courant électrique entre la ligne de courant amont (320) et la ligne de courant aval (330),
- un actionneur (2) agencé pour actionner le, au moins un, contact électrique (310),
- un dispositif de commande sécurisée (1) selon l'une quelconque des revendications précédentes, ledit dispositif de commande sécurisée (1) étant connecté à l'actionneur (2) pour fournir un premier ordre de commande sécurisée (Sig4) audit actionneur (2) afin de commander un actionnement du, au moins un, contact électrique (310),
- une première borne de raccordement (C1) connectée à un premier point de connexion (E1) dudit dispositif de commande sécurisée (1), et
- une deuxième borne de raccordement (C2) connectée à un deuxième point de connexion (E2) dudit dispositif de commande sécurisée (1),
contacteur (100) **caractérisé en ce que** le dispositif de commande sécurisée (1) commande l'actionneur (2):
- pour exécuter une fermeture du, au moins un, contact électrique (310) quand le premier ordre de commande sécurisée (Sig4) est un premier ordre de commande sécurisée de marche (Sig4_ON), ou
- pour exécuter une ouverture du, au moins un, contact électrique (310) quand le premier ordre de commande sécurisée (Sig4) est un premier ordre de commande sécurisée d'arrêt (Sig4_OFF).

10. Contacteur (100) selon la revendication précédente **caractérisé en ce qu'**il comporte, en outre, une troisième borne de raccordement (C3) connectée à un troisième point de connexion (E3) du dispositif de commande sécurisée (1), ledit dispositif de commande sécurisée (1) étant connecté à l'actionneur via une seconde sortie binaire (S2) pour fournir un troisième ordre de commande sécurisée (Sig50) à l'actionneur (2) et ainsi commander ledit actionneur (2) :
- pour exécuter une fermeture du, au moins un, contact électrique (310) quand le troisième ordre de commande sécurisée (Sig50) est un troisième ordre de commande sécurisée de marche (Sig50_ON), ou
- pour exécuter une ouverture du, au moins un, contact électrique (310) quand le troisième ordre de commande sécurisée (Sig50) est un troisième ordre de commande sécurisée d'arrêt (Sig50_OFF).

11. Procédé de traitement sécurisé d'un troisième signal (Sig3) formé d'au moins une impulsion (P) fournie par au moins un premier circuit récepteur (22) d'un dispositif de commande sécurisée (1) selon l'une des revendications précédentes 1-8, ledit procédé étant **caractérisé en ce qu'**il comporte un comptage itératif d'une quantité (Q) d'impulsions (P) fournies par le premier circuit récepteur (22) pendant un intervalle de temps (T) d'une durée prédéfinie.

12. Procédé de traitement sécurisé d'un troisième signal (Sig3) selon la revendication précédente, **caractérisé en ce qu'**un premier compteur (Q1) est incrémenté quand un nombre (Q) d'impulsions (P) comptées pendant un intervalle de temps (T) est compris entre un nombre minimum d'impulsions (Qmin) prédéfini et un nombre maximum d'impulsions (Qmax) prédéfini.

13. Procédé de traitement sécurisé d'un troisième signal (Sig3) selon la revendication précédente, **caractérisé en ce qu'**un premier ordre de commande sécurisée de marche (Sig4_ON) est généré quand le premier compteur (Q1) est égal ou supérieur à un seuil de validation (Qval) prédéfini.

14. Procédé de traitement sécurisé d'un troisième signal (Sig3) selon l'une des revendications 12 ou 13, **caractérisé en ce qu'**un second compteur (Q2) est incrémenté quand le nombre (Q) d'impulsions (P) comptées pendant l'intervalle de temps (T) n'est pas compris entre le nombre minimum d'impulsions (Qmin) et le nombre maximum d'impulsions (Qmax).

15. Procédé de traitement sécurisé d'un troisième signal (Sig3) selon la revendication précédente, **caractérisé en ce qu'**un premier ordre de commande sécurisée d'arrêt (Sig4_OFF) est généré quand le second compteur (Q2) est égal ou supérieur à un seuil d'invalidation (Qinv) prédéfini.

## Patentansprüche

1. Sichere Steuerungsvorrichtung (1) zum Verarbeiten eines Steuersignals (Sig1) und zum Erzeugen eines ersten sicheren Steuerbefehls (Sig4), die sichere Steuerungsvorrichtung (1) umfassend:
- einen Steuerungseingang (E), umfassend mindestens einem ersten Verbindungspunkt (E1) und einen zweiten Verbindungspunkt (E2), wobei der Steuerungseingang (E) angeordnet ist, um das Steuersignal (Sig1) zu empfangen,
- eine erste Schutzschaltung (10),
- einen ersten Koppler (20), umfassend:
- eine erste Senderschaltung (21), die mit der ersten Schutzschaltung (10) in Reihe verbunden ist, wobei die durch die erste Senderschaltung (21) und die erste Schutzschaltung (10) gebildete Einheit verbunden ist zwischen dem ersten Verbindungspunkt (E1) und dem zweiten Verbindungspunkt (E2), wobei die erste Senderschaltung (21) angeordnet ist, um ein zweites Signal (Sig2) zu senden, wenn das Steuersignal (Sig1) an dem Steuerungseingang (E) anliegt, und
- eine erste Empfängerschaltung (22), die angeordnet ist, um das zweite Signal (Sig2) zu empfangen und ein drittes Signal (Sig3) bereitzustellen, das aus mindestens einem Impuls (P) gebildet ist,
- einen ersten Schalter (30), der parallel zu der ersten Senderschaltung (21) verbunden ist,
- einen Impulsgenerator (40), der mit dem ersten Schalter (30) verbunden und angeordnet ist, um ein Öffnen und Schließen des ersten Schalters (30) zyklisch zu steuern, und
- eine erste Verarbeitungsschaltung (50), die mit der ersten Empfängerschaltung (22) verbunden ist, um das dritte Signal (Sig3) zu empfangen, wobei die erste Verarbeitungsschaltung (50) angeordnet ist, um das dritte Signal (Sig3) zu verarbeiten und den ersten sicheren Steuerbefehl (Sig4) bereitzustellen, wobei der erste sichere Steuerbefehl (Sig4) mindestens zwei Zustände annehmen kann:
- einen ersten sicheren Einschaltsteuerbefehl (Sig4_ON), oder
- einen ersten sicheren Abschaltsteuerbefehl (Sig4_OFF),
die erste Schutzschaltung (10) umfassend eine Strombegrenzungsschaltung (11) zum Begrenzen des durch die Schutzschaltung (10) fließenden Stroms (i), **dadurch gekennzeichnet, dass** die erste Schutzschaltung eine Stromschwellenerfassungsschaltung (12) umfasst, die mit der Strombegrenzungsschaltung (11) verbunden ist, um den durch die Schutzschaltung (10) fließenden Strom (i) auf eine vordefinierte maximale Stromstärke (I_{Max}) zu begrenzen, wenn die Amplitude (V_{sig1}) des Steuersignals (Sig1) größer ist als eine vordefinierte maximale Spannungsschwelle (U_{Max}), und dass eine Spannungsschwellenerfassungsschaltung (13) mit der ersten Schutzschaltung (10) und der ersten Senderschaltung (21) in Reihe verbunden ist, um den durch die Senderschaltung (21) fließenden Strom (i) auf einen vordefinierten Mindeststrom (Iₘᵢₙ) zu begrenzen, wenn die Amplitude (V_{sig1}) des Steuersignals (Sig1) kleiner ist als eine vordefinierte Mindestspannungsschwelle (Uₘᵢₙ).

2. Sichere Steuerungsvorrichtung (1) nach Anspruch 1, **dadurch gekennzeichnet, dass** die erste Senderschaltung (21) und der erste Empfängerkreis (22) galvanisch voneinander isoliert sind.

3. Sichere Steuerungsvorrichtung (1) nach einem der Ansprüche 1 oder 2, **dadurch gekennzeichnet, dass** der erste Koppler (20) mindestens einen Optokoppler umfasst, die erste Senderschaltung (21) umfassend eine Senderdiode (D) und die erste Empfängerschaltung (22) umfassend einen Fototransistor (Tr), wobei die Senderdiode (D) eine Strahlung aussendet, die ein Übertragungsmedium für das zweite Signal (Sig2) zu dem Fototransistor (Tr) durch eine für die Strahlung transparente und elektrisch isolierende Wand (Sc) hindurch bildet.

4. Sichere Steuerungsvorrichtung (1) nach einem der vorherigen Ansprüche, **dadurch gekennzeichnet, dass** der Impulsgenerator (40) Impulse mit einem vordefinierten Tastverhältnis erzeugt, das kleiner als oder gleich wie 50 % ist.

5. Sichere Steuerungsvorrichtung (1) nach einem der vorherigen Ansprüche, **dadurch gekennzeichnet, dass** der Impulsgenerator (40) Impulse mit einer Frequenz zwischen 100 Hz und 10 kHz erzeugt.

6. Sichere Steuerungsvorrichtung (1) nach einem der vorherigen Ansprüche, **dadurch gekennzeichnet, dass** der erste Schalter (30) in Reihe mit der ersten Schutzschaltung (10) verbunden ist.

7. Sichere Steuerungsvorrichtung (1) nach einem der vorherigen Ansprüche, **dadurch gekennzeichnet, dass** sie ferner Folgendes umfasst:
- einen Validierungseingang (V), umfassend einen dritten Verbindungspunkt (E3), wobei der Validierungseingang (V) angeordnet ist, um ein Validierungssignal (Sig10) zu empfangen,
- eine zweite Schutzschaltung (110),
- einen zweiten Koppler (120), umfassend:
- eine zweite Senderschaltung (121), die mit der zweiten Schutzschaltung (110) in Reihe verbunden ist, wobei die durch die zweite Senderschaltung (121) und die zweite Schutzschaltung (110) gebildete Einheit zwischen dem dritten Verbindungspunkt (E3) und dem zweiten Verbindungspunkt (E2) der sicheren Steuerungsvorrichtung (1) verbunden ist, wobei die zweite Senderschaltung (121) angeordnet ist, um ein viertes Signal (Sig20) auszusenden, wenn das Validierungssignal (Sig10) an dem Validierungseingang (V) anliegt, und
- eine zweite Empfängerschaltung (122), die angeordnet ist, um das vierte Signal (Sig20) zu empfangen und ein fünftes Signal (Sig30) auszusenden,
- einen zweiten Schalter (130), der einerseits parallel zu der zweiten Senderschaltung (121) verbunden ist und andererseits mit dem Impulsgenerator (40) verbunden ist, damit der Impulsgenerator (40) zyklisch ein Öffnen und Schließen des zweiten Schalters (130) steuert,
- eine zweite Verarbeitungsschaltung (150), die mit der zweiten Empfängerschaltung (122) verbunden ist, um das fünfte Signal (Sig30) zu empfangen, wobei die zweite Verarbeitungsschaltung (150) angeordnet ist, um das fünfte Signal (Sig30) zu verarbeiten und einen zweiten sicheren Steuerbefehl (Sig40) bereitzustellen, wobei der zweite sichere Steuerbefehl (Sig40) mindestens zwei Zustände annehmen kann:
- einen zweiten sicheren Betriebsteuerbefehl (Sig40_ON), oder
- einen zweiten sicheren Abschaltsteuerbefehl (Sig40_OFF),
- eine Logikschaltung (160), umfassend:
- einen ersten Binäreingang (L1), der mit der ersten Verarbeitungsschaltung (50) verbunden ist, um den ersten sicheren Steuerbefehl (Sig4) zu empfangen,
- einen zweiten Binäreingang (L2), der mit der zweiten Verarbeitungsschaltung (150) verbunden ist, um den zweiten sicheren Steuerbefehl (Sig40) zu empfangen, und
- einen zweiten binären Ausgang (S2), um einen dritten sicheren Steuerbefehl (Sig50) bereitzustellen.

8. Sichere Steuerungsvorrichtung (1) nach einem der vorherigen Ansprüche, **dadurch gekennzeichnet, dass** der dritte sichere Steuerbefehl (Sig50) mindestens zwei Zustände annimmt:
- einen dritten sicheren Einschaltsteuerbefehl (Sig50_ON), wenn ein erster sicherer Steuerbefehl (Sig4), der von der sicheren Steuerungsvorrichtung bereitgestellt wird (1) ein erster sicherer Einschaltsteuerbefehl (Sig4_ON) ist und wenn der zweite sichere Steuerbefehl (Sig40) ein zweiter sicherer Einschaltsteuerbefehl (Sig40_ON) ist, oder
- einen dritten sicheren Abschaltsteuerbefehl (Sig50_OFF), wenn ein erster sicherer Steuerbefehl (Sig4), der von der sicheren Steuerungsvorrichtung (1) bereitgestellt wird, ein erster sicherer Abschaltsteuerbefehl (Sig4_OFF) ist oder der zweite sichere Steuerbefehl (Sig40) ein zweiter sicherer Abschaltsteuerbefehl (Sig40_OFF) ist.

9. Schutzschalter (100), umfassend:
- mindestens einen elektrischen Kontakt (310), der mit einer stromaufwärtigen Stromleitung (320) und einer stromabwärtigen Stromleitung (330) verbunden ist, wobei der elektrische Kontakt (310) angeordnet ist, um den Fluss eines elektrischen Stroms zwischen der stromaufwärtigen Stromleitung (320) und der stromabwärtigen Stromleitung (330) zu ermöglichen oder zu unterbrechen,
- einen Aktuator (2), der angeordnet ist, um den mindestens einen elektrischen Kontakt (310) zu betätigen,
- eine sichere Steuerungsvorrichtung (1) nach einem der vorherigen Ansprüche, wobei die sichere Steuerungsvorrichtung (1) mit dem Aktuator (2) verbunden ist, um einen ersten sicheren Steuerbefehl (Sig4) an den Aktuator (2) bereitzustellen, um eine Betätigung des mindestens einen elektrischen Kontakts (310) zu steuern,
- einen ersten Verbindungsanschluss (C1), der mit einem ersten Verbindungspunkt (E1) der sicheren Steuerungsvorrichtung (1) verbunden ist,
und
- einen zweiten Verbindungsanschluss (C2), der mit einem zweiten Verbindungspunkt (E2) der gesicherten Steuerungsvorrichtung (1) verbunden ist, wobei der Schutzschalter (100) **dadurch gekennzeichnet ist, dass** die sichere Steuerungsvorrichtung (1) den Aktuator (2) steuert:
- um ein Schließen des mindestens einen elektrischen Kontakts (310) auszuführen, wenn der erste sichere Steuerbefehl (Sig4) ein erster sicherer Einschaltsteuerbefehl (Sig4_ON) ist, oder
- um ein Öffnen des mindestens einen elektrischen Kontakts (310) auszuführen, wenn der erste sichere Steuerbefehl (Sig4) ein erster sicherer Abschaltsteuerbefehl (Sig4_OFF) ist.

10. Schutzschalter(100) nach dem vorherigen Anspruch, **dadurch gekennzeichnet, dass** er ferner einen dritten Verbindungsanschluss (C3) umfasst, der mit einem dritten Verbindungspunkt (E3) der sicheren Steuerungsvorrichtung (1) verbunden ist, wobei die sichere Steuerungsvorrichtung (1) über einen zweiten Binärausgang (S2) mit dem Aktuator verbunden ist, um einen dritten sicheren Steuerbefehl (Sig50) an den Aktuator (2) bereitzustellen und somit den Aktuator (2) zu steuern:
- um ein Schließen des mindestens einen elektrischen Kontakts (310) auszuführen, wenn der dritte sichere Steuerbefehl (Sig50) ein dritter sicherer Einschaltsteuerbefehl (Sig50_ON) ist, oder
- um ein Öffnen des mindestens einen elektrischen Kontakts (310) auszuführen, wenn der dritte sichere Steuerbefehl (Sig50) ein dritter sicherer Abschaltsteuerbefehl (Sig50_OFF) ist.

11. Sicheres Verarbeitungsverfahren eines dritten Signals (Sig3), das aus mindestens einem Impuls (P) gebildet ist, der von mindestens einer ersten Empfängerschaltung (22) einer sicheren Steuerungsvorrichtung (1) nach einem der vorherigen Ansprüche
1-8 bereitgestellt wird,
wobei das Verfahren **dadurch gekennzeichnet ist, dass** es ein iteratives Zählen einer Menge (Q) von Impulsen (P) umfasst, die von der ersten Empfängerschaltung (22) während eines Zeitintervalls (T) mit einer vordefinierten Dauer bereitgestellt werden.

12. Sicheres Verarbeitungsverfahren eines dritten Signals (Sig3) nach dem vorherigen Anspruch, **dadurch gekennzeichnet, dass** ein erster Zähler (Q1) inkrementiert wird wenn eine Anzahl (Q) von Impulsen (P), die während eines Zeitintervalls (T) gezählt werden, zwischen einer vordefinierten minimalen Anzahl von Impulsen (Qmin) und einer vordefinierten maximalen Anzahl von Impulsen (Qmax) ist.

13. Sicheres Verarbeitungsverfahren eines dritten Signals (Sig3) nach dem vorherigen Anspruch, **dadurch gekennzeichnet, dass** ein erster Einschaltsteuerbefehl (Sig4_ON) erzeugt wird, wenn der erste Zähler (Q1) gleich wie oder größer als eine vordefinierte Validierungsschwelle (Qval) ist.

14. Sicheres Verarbeitungsverfahren eines dritten Signals (Sig3) nach einem der Ansprüche 12 oder 13, **dadurch gekennzeichnet, dass** ein zweiter Zähler (Q2) inkrementiert wird, wenn die Anzahl (Q) der Impulse (P), die während des Zeitintervalls (T) gezählt werden, nicht zwischen der minimalen Anzahl von Impulsen (Qmin) und der maximalen Anzahl von Impulsen (Qmax) ist.

15. Sicheres Verarbeitungsverfahren eines dritten Signals (Sig3) nach dem vorherigen Anspruch, **dadurch gekennzeichnet, dass** ein erster sicherer Abschaltsteuerbefehl (Sig4_OFF) erzeugt wird, wenn der zweite Zähler (Q2) gleich wie oder größer als ein vordefinierter Ungültigkeitsschwellenwert (Qinv) ist.

## Claims

1. A secure control device (1) for processing a control signal (Sig1) and generating a first secure control command (Sig4), said secure control device (1) comprising:
- a control input (E) comprising at least a first connection point (E1) and a second connection point (E2), said control input (E) being arranged to receive the control signal (Sig1),
- a first protection circuit (10),
- a first coupler (20) comprising:
- a first transmitter circuit (21) connected in series with the first protection circuit (10), the assembly formed by the first transmitter circuit (21) and the first protection circuit (10) being connected between the first connection point (E1) and the second connection point (E2), said first transmitter circuit (21) being arranged to emit a second signal (Sig2) when the control signal (Sig1) is present on the control input (E), and
- a first receiver circuit (22) arranged to receive the second signal (Sig2) and to supply a third signal (Sig3) consisting of at least one pulse (P),
- a first switch (30) connected in parallel with the first emitter circuit (21),
- a pulse generator (40) connected to the first switch (30) and arranged to cyclically control opening and closing of the first switch (30), and
- a first processing circuit (50) connected to the first receiver circuit (22) for receiving the third signal (Sig3), said first processing circuit (50) being arranged to process the third signal (Sig3) and supply the first secure control command (Sig4), said first secure control command (Sig4) being able to take at least two states:
- a first secure run command (Sig4_ON), or
- a first secure stop command (Sig4_OFF),
the first protection circuit (10) with a current limiting circuit (11) to limit the current (i) flowing through that protection circuit (10), **characterised by** the first protection circuit having a current threshold detection circuit (12) connected to the current limiting circuit (11) to limit the current (i) flowing through the protection circuit (10) to a predefined maximum current (I_{Max}) when the amplitude (V_{sig1}) of the control signal (Sig1) is greater than a predefined maximum voltage threshold (U_{Max}), and that a voltage threshold detection circuit (13) is connected in series with the first protection circuit (10) and the first transmitter circuit (21) to limit the current (i) flowing through said transmitter circuit (21) to a predefined minimum intensity (Iₘᵢₙ) when the amplitude (V_{sig1}) of the control signal (Sig1) is below a predefined minimum voltage threshold (Uₘᵢₙ).

2. A secure control device (1) as claimed in claim 1, **characterised in that** the first transmitter circuit (21) and the first receiver circuit (22) are galvanically isolated from each other.

3. A secure control device (1) according to one of claims 1 or 2, **characterised in that** the first coupler (20) comprises at least one optocoupler, the first emitter circuit (21) comprising an emitter diode (D) and the first receiver circuit (22) comprising a phototransistor (Tr), the emitter diode (D) emitting radiation forming a medium for transmitting the second signal (Sig2) to the phototransistor (Tr), through a radiation-transparent and electrically insulating wall (Sc).

4. A secure control device (1) according to any one of the preceding claims, **characterised in that** the pulse generator (40) generates pulses with a predefined duty cycle less than or equal to 50%.

5. A secure control device (1) according to any one of the preceding claims, **characterised in that** the pulse generator (40) generates pulses at a frequency of between 100 Hz and 10 kHz.

6. A secure control device (1) according to any one of the preceding claims, **characterised in that** the first switch (30) is connected in series with the first protection circuit (10).

7. A secure control device (1) according to any of the previous claims, **characterised in that** it also includes:
- an enable input (V) comprising a third connection point (E3), said enable input (V) being arranged to receive an enable signal (Sig10),
- a second protection circuit (110),
- a second coupler (120) comprising:
- a second transmitter circuit (121) connected in series with the second protection circuit (110), the assembly formed by the second transmitter circuit (121) and the second protection circuit (110) being connected between the third connection point (E3) and the second connection point (E2) of the secure control device (1), said second transmitter circuit (121) being arranged to transmit a fourth signal (Sig20) when the enable signal (Sig10) is present at the enable input (V), and
- a second receiver circuit (122) arranged to receive the fourth signal (Sig20) and to supply a fifth signal (Sig30),
- a second switch (130) connected, on the one hand, in parallel to the second emitter circuit (121), and connected, on the other hand, to the pulse generator (40) so that said pulse generator (40) cyclically controls opening and closing of said second switch (130),
- a second processing circuit (150) connected to the second receiver circuit (122) to receive the fifth signal (Sig30), the said second processing circuit (150) being arranged to process the fifth signal (Sig30) and to supply a second secure control command (Sig40), the said second secure control command (Sig40) being able to assume at least two states:
- a second secure run command (Sig40_ON) and
- a second secure stop command (Sig40_OFF),
- a logic circuit (160) comprising:
- a first binary input (L1) connected to the first processing circuit (50) to receive the first secure control command (Sig4),
- a second binary input (L2) connected to the second processing circuit (150) to receive the second secure control command (Sig40), and
- a second binary output (S2) to supply a third secure control command (Sig50).

8. A secure control device (1) according to any one of the preceding claims, **characterised in that** the third secure control command (Sig50) assumes at least two states:
- a third secure ON command (Sig50_ON) when a first secure command (Sig4) provided by the secure control device (1) is a first secure ON command (Sig4_ON) and when the second secure command (Sig40) is a second safe on command (Sig40_ON), or
- a third stop secure control command (Sig50_OFF) when a first secure control command (Sig4) supplied by the secure control device (1) is a first stop secure command (Sig4_OFF) or the second secure command (Sig40) is a second stop secure command (Sig40_OFF).

9. A switch (100) to include:
- at least one electrical contact (310) connected to an upstream current line (320) and a downstream current line (330), said electrical contact (310) being arranged to allow the passage or stopping of the flow of an electrical current between the upstream current line (320) and the downstream current line (330),
- an actuator (2) arranged to operate the at least one electrical contact (310),
- a secure control device (1) according to any one of the preceding claims, said secure control device (1) being connected to the actuator (2) to supply a first secure control command (Sig4) to said actuator (2) in order to control actuation of the at least one electrical contact (310),
- a first connection terminal (C1) connected to a first connection point (E1) of said secure control device (1), and
- a second connection terminal (C2) connected to a second connection point (E2) of said secure control device (1), a switch (100) **characterised in that** the secure control device (1) controls the actuator (2):
- to execute a closure of the at least one electrical contact (310) when the first secure control command (Sig4) is a first secure run control command (Sig4_ON), or
- to execute an opening of the at least one electrical contact (310) when the first secure control command (Sig4) is a first secure stop control command (Sig4_OFF).

10. A switch (100) according to the preceding claim, **characterised in that** it further comprises a third connection terminal (C3) connected to a third connection point (E3) of the secure control device (1), said secure control device (1) being connected to the actuator via a second binary output (S2) to supply a third secure control command (Sig50) to the actuator (2) and thus control said actuator (2):
- to execute a closure of the at least one electrical contact (310) when the third secure control command (Sig50) is a third secure run control command (Sig50_ON), or
- to execute an opening of the at least one electrical contact (310) when the third secure control command (Sig50) is a third secure stop control command (Sig50_OFF).

11. A method for secure processing of a third signal (Sig3) formed by at least one pulse (P) supplied by at least one first receiver circuit (22) of a secure control device (1) according to one of the claims
previous 1-8,
said method being **characterised in that** it comprises iterative counting of a quantity (Q) of pulses (P) supplied by the first receiver circuit (22) during a time interval (T) of a predefined duration.

12. A method for secure processing of a third signal (Sig3) according to the preceding claim, **characterised in that** a first counter (Q1) is incremented when a number (Q) of pulses (P) counted during a time interval (T) is between a predefined minimum number of pulses (Qmin) and a predefined maximum number of pulses (Qmax).

13. A method for secure processing of a third signal (Sig3) according to the preceding claim, **characterised in that** a first selective run command (Sig4_ON) is generated when the first counter (Q1) is equal to or greater than a predefined validation threshold (Qval).

14. A method for secure processing of a third signal (Sig3) according to one of claims 12 or 13, **characterised in that** a second counter (Q2) is incremented when the number (Q) of pulses (P) counted during the time interval (T) does not lie between the minimum number of pulses (Qmin) and the maximum number of pulses (Qmax).

15. A method for secure processing of a third signal (Sig3) according to the preceding claim, **characterised in that** a first selective stop command (Sig4_OFF) is generated when the second counter (Q2) is equal to or greater than a predefined disabling threshold (Qinv).
